# EUROPEAN PATENT SPECIFICATION

(11) **EP 2 556 783 B1**
(45) Date of publication and mention of the grant of the patent: **11.10.2017**
(21) Application number: 12179512.4
(22) Date of filing: 07.08.2012
(51) Int. Cl.: A47L 15/42, H05K 5/02, H02G 3/22

(54) **Dishwasher and home appliance**
Geschirrspülmaschine und Haushaltgerät
Lave-vaisselle et appareil électroménager

(30) Priority: 12.08.2011 KR 20110080877
(43) Date of publication of application: 13.02.2013
(73) Proprietor: Samsung Electronics Co., Ltd., Suwon-si, Gyeonggi-do, 443-742 (KR)
(72) Inventor: Lee, Choon Woo, Gyeonggi-do (KR)
(74) Representative: Grünecker Patent- und Rechtsanwälte PartG mbB

(56) References cited:
- WO-A1-2006/062343
- WO-A1-2008/122851
- DE-U1- 20 303 849
- US-A1- 2005 120 586

## Description

### BACKGROUND

### 1. Field

Embodiments of the present disclosure relate to a coupling structure of a power cord, and more particularly, to a coupling structure of a power cord having an enhanced structure in assembling and disassembling a power cord of a housing of a dishwasher and a home appliance.

### 2. Description of the Related Art

In general, an electronic appliance such as a washing machine, a refrigerator, or an air conditioner operates by receiving a power from an outside power supply source, and is provided with a power cord. The power cord includes a cable which is configured to distribute the power to various components that are equipped at an electronic appliance, and a plug which is coupled to one end of the cable.

Such a power cord is installed to be exposed to the outside of a housing which forms an exterior of the electronic appliance. The housing has a power cord insertion hole that allows the cable to the power cord to pass therethrough, and the power cord penetrates through the power cord insertion hole and is extended to outside.

In general, the power cord insertion hole is formed larger than the thickness of the cable of the power cord, and therefore, a foreign substance may be entered through the power cord insertion hole. For such a reason, in coupling the power cord to the housing, there is a need for a coupling structure of a power cord capable of support a power cord while sealing the power cord insertion hole.

In a case of a dishwasher, for an example, the dishwasher includes a rack which is configured for tableware to be received at the inside of a tub, an injection nozzle which is configured for cleaning water to be injected on the tableware received on the rack, a sump which is configured to supply the injection nozzle with the cleaning water, a cleaning pump, and a cleaning motor.

The coupling structure of the power cord is formed at a base installed at the lower portion of the tub of the dishwasher.

A general dishwasher having the structure described above is composed in a way that the power is authorized through the power cord installed at one side of the base, and that the cleaning water stored inside of the sump is injected through the injection nozzle as the cleaning pump is operated.

A ferrite core may be coupled to the power cord for restraining the occurrence of low frequency noise, and a structure such as a fuse holder may further be provided. As such, in a case when a component having a large size is coupled to the power cord, assembling and disassembling the power cord from the housing is difficult because fixing the power cord to the housing is uneasy due to an enlarged size and separate component is used in many cases.

WO 2008/122851 A1 discloses a washing machine with a housing forming an exterior and a tableware cleaning tub formed at an inside of the housing. A power cord is used to supply a power and the housing comprises a number of parts like a housing body, a power cord insertion hole and also an open/close unit. The power cord insertion hole is provided in one side of the housing body for a portion of the power cord to be inserted into the inside of the housing. The open/close unit is equipped with a first accommodation groove to accommodate the portion of the power cord inserted into the inside of the housing.

### SUMMARY

Therefore, it is an aspect of the present disclosure to provide a coupling structure of a power cord having an enhanced structure of a housing body which is made capable for an easy assembly and disassembly even in a case of having a large component coupled to the power cord, and which is made capable for the easy additional component.

Additional aspects of the invention will be set forth in part in the description which follows and, in part, will be obvious from the description, or may be learned by practice of the invention.

In accordance with one aspect of the present disclosure, a dishwasher includes a dishwasher including a housing configured to form an exterior, a tableware cleaning tub formed at an inside of the housing, and a power code configured to supply a power. The housing includes a housing body, a power code, and an open/close unit. The power code insertion hole is provided at one side of the housing body for a portion of the power code to be inserted into an inside of the housing. The open/close unit is rotatably coupled to the housing body to open/close the power cord insertion hole. The open/close unit is equipped with a first accommodation groove to accommodate the portion of the power code inserted into the inside of the housing. The power code includes a fixing unit configured to fix the power code to the housing body when the open/close unit closes the power code insertion hole. The fixing unit includes a coupling member which is coupled to the first accommodation groove of the open/close unit, and a fixing member which is fixed to the housing body.

The coupling member of the power code includes a neck part which is inserted into the first accommodation groove and a head part which is supported by an inner side of the open/close unit when the neck part is inserted into the first accommodation groove.

A portion of the fixing member is disposed to be supported by an outer side of the open/close unit, and another portion of the fixing member is disposed to be supported by an outer side of the housing body when the open/close unit closes the power cord insertion hole in a state when the neck part is inserted into the first accommodation groove.

The housing body includes a second accommodation groove which is formed to face the first accommodation groove when the open/close unit closes the power code insertion hole.

A portion of the coupling member is disposed to be supported by an inner side of the housing body when the open/close unit closes the power code insertion hole in a state that the neck part is inserted into the first accommodation groove.

The first accommodation groove of the open/close unit and the second accommodation groove of the housing body face each other toward a first direction, and

A length of the first accommodation groove toward the first direction is longer than a length of the second accommodation groove toward the first direction.

The dishwasher further includes a fastening member which is configured to fix the fixing member to the housing body.

The dishwasher further includes a recess which is formed in steps at an outer side of the housing body.

The open/close unit is formed integrally with the housing body.

The open/close unit is detachably installed to the housing body.

A ferrite core is coupled to a rear of the coupling member of the power code to restrain occurrence of low frequency noise.

As described above, in accordance with the embodiments of the present disclosure, even in a case when a large component such as a ferrite core or fuse holder is coupled to the rear of a coupling member of a power cord, a power cord may be easily coupled to a home appliance without an additional component.

### BRIEF DESCRIPTION OF THE DRAWINGS

These and/or other aspects of the invention will become apparent and more readily appreciated from the following description of the embodiments, taken in conjunction with the accompanying drawings of which:
FIG. 1 is a side sectional view illustrating a structure of a dishwasher in accordance with an embodiment of the present disclosure.
FIG. 2 is a view illustrating a coupling structure of a power cord and a dishwasher in accordance with the embodiment of the present disclosure.
FIG. 3 is an exploded view illustrating a disassembled state of the power cord and the dishwasher in accordance with the embodiment of the present disclosure.
FIG. 4 is a side view illustrating a state of the power cord coupled to the dishwasher in accordance with the embodiment of the present disclosure.
FIG. 5 is a view illustrating a housing body of the dishwasher to which the power cord is coupled in accordance with the embodiment of the present disclosure.
FIG. 6 is a view illustrating an open state of an open/close unit in accordance with the embodiment of the present disclosure.
FIG. 7 is a side view illustrating the open state of the open/close unit in accordance with the embodiment of the present disclosure.
FIG. 8 is an exploded view illustrating the disassembled state of the dishwasher and the power cord.

### DETAILED DESCRIPTION

Reference will now be made in detail to the embodiments of the present disclosure, examples of which are illustrated in the accompanying drawings, wherein like reference numerals refer to like elements throughout.

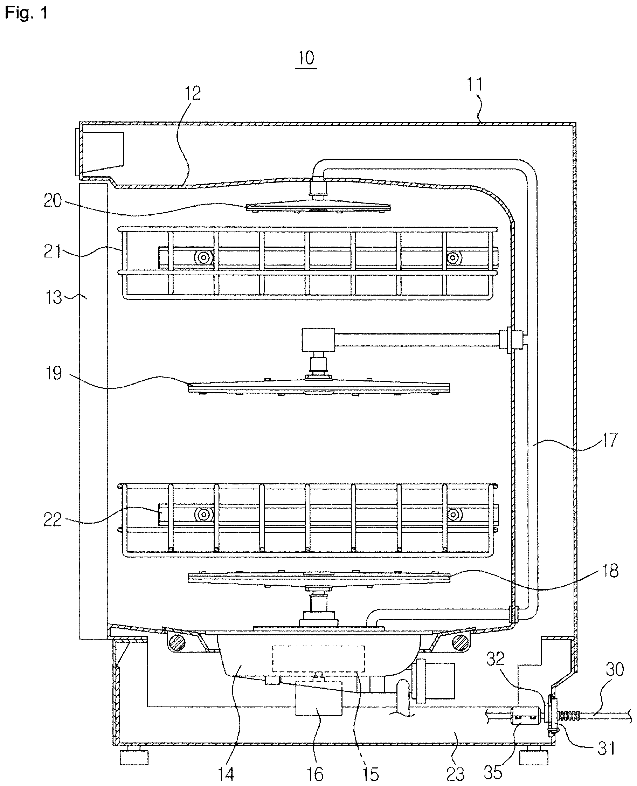

FIG. 1 is a side sectional view illustrating a structure of a dishwasher according to an embodiment of the present disclosure.

Referring to FIG. 1, a dishwasher 10 to which a power cord 30 is coupled, includes a housing 11 which forms an exterior, a tub 12 which is protected by the housing 11 and at which a tableware cleaning tub is formed, and a door 13 which is formed at the front of the tub 12 and configured to open/close the tableware cleaning tub.

In addition, the dishwasher 10 includes a sump 14 which is formed at a central portion of the lower surface of the tub 12and at where a cleaning water is stored, a cleaning pump 15 which is connected to the sump 14 and configured to pump the cleaning water stored at the sump 14, and a motor 16 which is disposed at the rear of the cleaning pump 15 and configured to drive the cleaning pump 15.

In addition, the dishwasher 10 includes a water guide 17 which becomes a moving path for the cleaning water which is pumped at the cleaning pump 15, a lower portion nozzle 18 which is formed at the lower portion of the cleaning tub and configured to inject the cleaning water toward an upper direction, and an upper portion nozzle 19 which is split from one point of the water guide 17 and positioned at about a central portion at the inside of the tub 12. A top nozzle 20 is equipped at a ceiling portion of the tub 12 to inject the cleaning water in a perpendicular direction toward a bottom. An upper rack 21 is installed at the upper side portion of the upper nozzle 19 and a lower rack 22 is installed between the upper nozzle 19 and the lower nozzle 20.

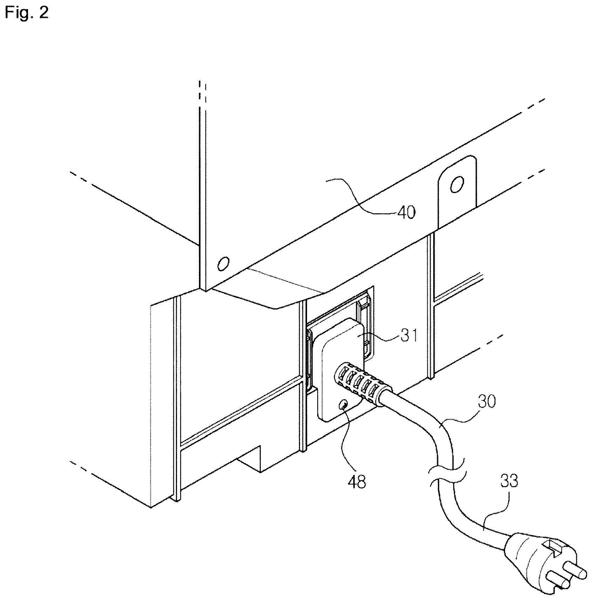

A base 23 is installed at a lower side of the tub 12, and the power cord 30 is installed at one side of the housing body 40 (refer to FIG. 2) which is one portion of the base 23.

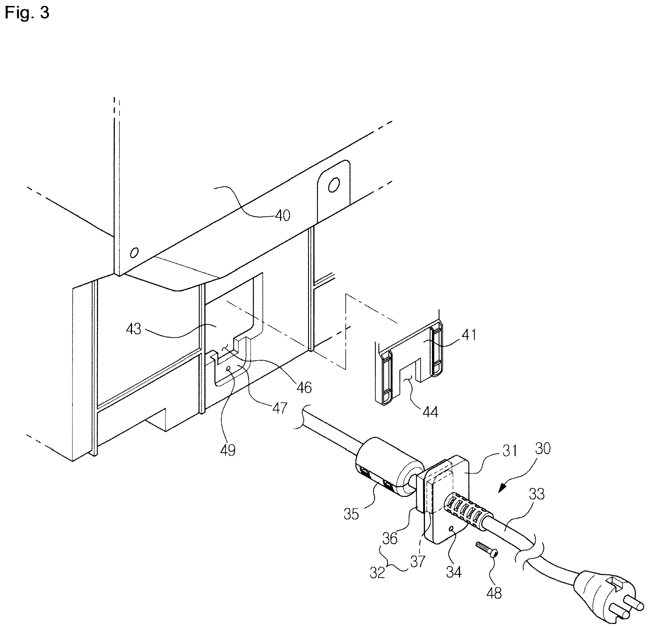

FIG. 2 is a view illustrating a coupling structure of a power cord and a dishwasher in accordance with the embodiment of the present disclosure, and FIG. 3 is an exploded view illustrating a disassembled state of a power cord and a dishwasher in accordance with the embodiment of the present disclosure.

Referring to FIGS. 2 to 3, the power cord 30 is coupled to the housing body 40 which is one side surface of the housing 11 of the dishwasher 10. The housing body 40 is provided at one surface with a power cord insertion hole 43 into which the power cord 30 is inserted. In addition, an open/close unit 41 which is configured to open/close the power cord insertion hole 43 is rotatably connected to the housing body 40. In accordance with the embodiment of the present disclosure, each of the three sides of the open/close unit 41 is incised, and the open/close unit 41 is configured not to be completely separated from the housing body 40.

The open/close unit 41 includes a first accommodation groove 44 which is concavely carved for accommodating a portion of the power cord 30. In addition, the housing body 40 includes a second accommodation groove 46 which is concavely carved and is formed in a way that the first accommodation groove 44 and the second accommodation groove 46 face each other when the open/close unit 41 closes the power cord insertion hole 43.

The housing body 40 includes a recess 47 which is formed in steps with respect to a side surface of the outer side of the housing 11. The recess 47 may be formed around the second accommodation groove 46. The recess 47, when the power cord 30 is coupled, has an effect in improving assemblage.

The second accommodation groove 46 is provided at a lower side with a housing fastening hole 49 into which a fastening member 48 configured to assemble the power cord 30 to the housing body 40 is inserted. The housing fastening hole 49 may be formed at an inside of the recess 47.

The power cord 30 includes a wire unit 33 which connects to an outside power supply source (not shown) and a fixing unit which fixes the power cord 30 to the housing 11. The fixing unit fixes the power cord 30 to the housing 11 when the open/close unit 41 closes the power cord insertion hole 43. In addition, the power cord 30 is coupled to the open/close unit 41 and the housing body 40 by the fixing unit so that the open/close unit 41 is fixed to the housing body 40. The fixing unit includes a coupling member 32 and a fixing member 31. In addition, the coupling member 32 may include a neck part 37 and a head part 36.

In addition, a ferrite core 35 may be equipped at the rear of the coupling member 32 of the power cord 30 to restrain the occurrence of low frequency noise. In the same manner as the ferrite core 35, a fuse holder (not shown) may be coupled to the rear of the coupling member 32. The fuse holder (not shown) is configured to protect a fuse (not shown), and a fuse (not shown) short-circuits for a current not to flow when an overvoltage is applied.

The power cord fastening hole 49 may be provided at the lower side of the fixing member 31 of the power cord 30 such that the fastening member 48 such as a screw is inserted into the power cord fastening hole 49 for the assembly of the power cord 30 and the housing 11.

The first accommodation groove 44 is coupled to the coupling member 32 in a case when the power cord 30 is being assembled, and the second accommodation groove 46 is equipped for easier assembly of the power cord 30. Therefore, the first accommodation groove 44 of the open/close unit 41 and the second accommodation groove 46 of the housing body 40 face each other in a first direction, and the length of the first accommodation groove 44 toward the first direction may be longer than the length of the second accommodation groove 46 toward the first direction.

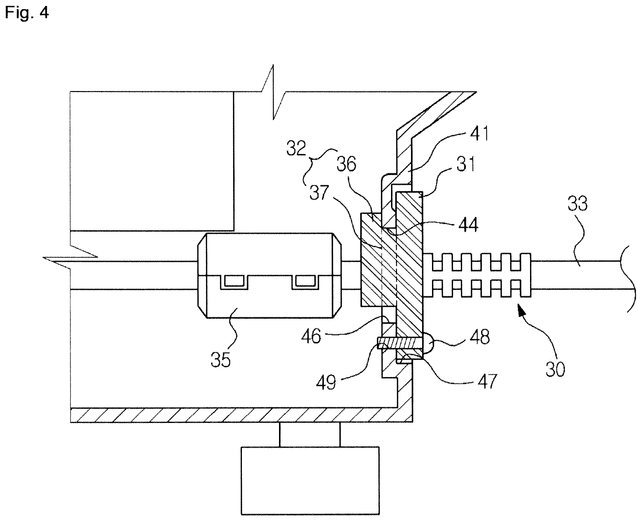

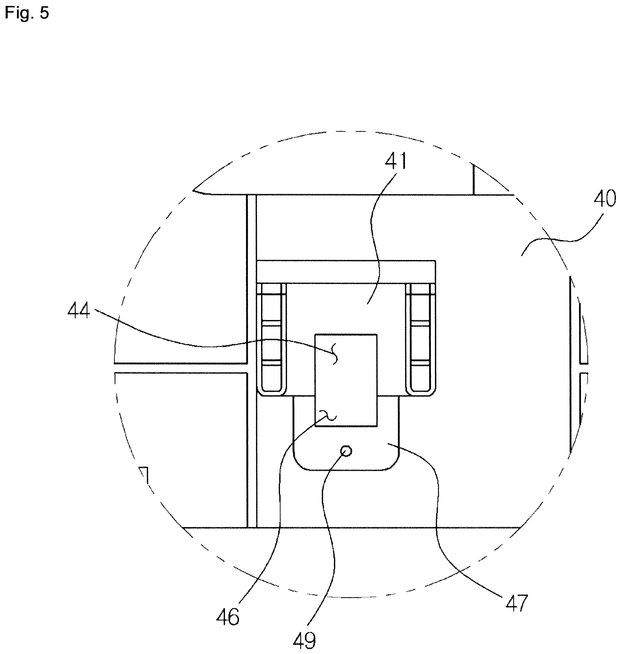

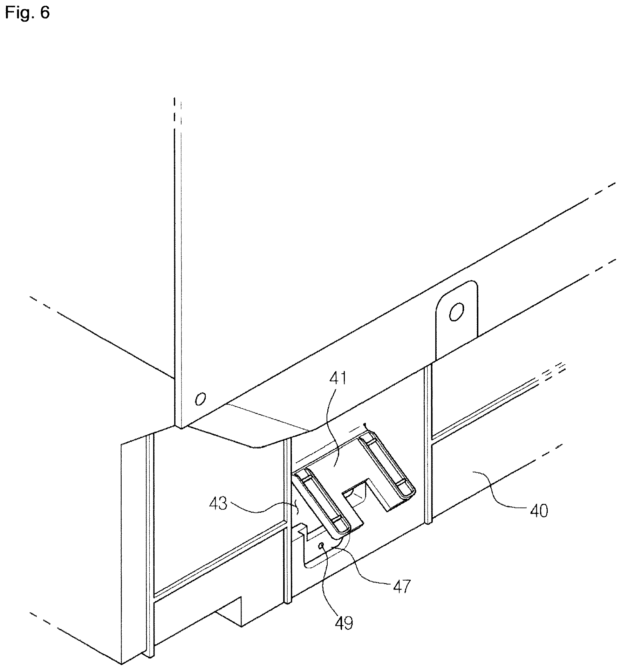

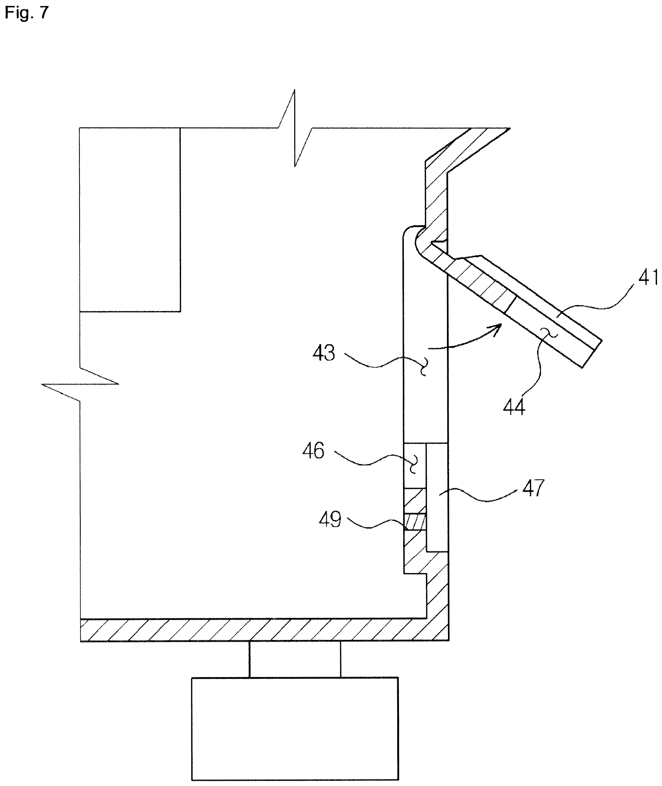

FIG. 4 is a side view illustrating a state of a power side is coupled to a dishwasher in accordance with the embodiment of the present disclosure, FIG. 5 is a view illustrating a housing body of a dishwasher to which a power cord is coupled in accordance with the embodiment of the present disclosure, FIG. 6 is a view illustrating an open state of an open/close unit in accordance with the embodiment of the present disclosure, and FIG. 7 is a side view illustrating an open state of an open/close unit in accordance with the embodiment of the present disclosure.

Referring to FIGS. 4 to 7, the open/close unit 41 is rotatable and is lifted toward the upper side of the housing body 40 for coupling of the power cord 30, so that the component having a large volume such as the ferrite core 35 and the fuse holder (not shown) which are attached to the power cord 30 is inserted through the power cord insertion hole 43. After coupling the power cord 30 to the housing body 40, the open/close unit 41 rotates toward the housing body 40 to its original state.

In accordance with the embodiment of the present disclosure, the open/close unit 41 is integrally formed with the housing body 40, and is manufactured through an injection molding method. The housing 11 which includes the housing body 40 includes plastic material.

The coupling member 32 of the power cord 30 is coupled to the first accommodation groove 44 of the open/close unit 41, and the fixing member 31 is fixed to the housing body 40. The coupling member 32 may include the neck part 37 which is inserted into the first accommodation groove 44 of the open/close unit 41, and the head part 36 which is supported by an inner surface of the open/close unit 41 when the neck part 37 is inserted into the first accommodation groove 44.

When the open/close unit 41 closes the power cord insertion hole 43 in a state that the neck part 37 is inserted into the first accommodation groove 44, a portion of the fixing member 31 of the power cord 30 is supported by an outer surface of the open/close unit 41 while another portion of the fixing member 31 is disposed to be supported by an outer surface of the housing body 40. The other portion of the fixing unit 31 supported by the outer surface of the housing body 40 is coupled to the recess 47 formed at the housing body 40, so that the power cord 30 may be stably assembled to the housing 11.

In a case when the housing 11 is coupled to the power cord 30, the housing fastening hole 49 provided at the lower side of the second accommodation groove 46 of the housing body 40 is disposed to overlap a power cord fastening hole 34 provided at the fixing member 31 of the power cord 30. Therefore, the fastening member 48 is inserted into the housing fastening hole 49 and the power cord fastening hole 34, thereby coupling the housing 11 to the power cord 30. By inserting the fastening member 48 such as a screw into the housing fastening hole 49 and into the power cord fastening hole 34, one portion of the fixing member 31 of the power cord 30 is coupled to the housing body 40, thereby improving the coupling strength of the power cord 30 and the housing 11.

The fixing member 31, as illustrated on FIG. 4, may be formed in a rectangular shape, and also in a circular shape as well as in other polygonal shapes. In a case when the power cord 30 is assembled at the housing 11 of the dishwasher 10, the power cord 30 is inserted into the power cord insertion hole 43 through the first accommodation groove 44 and the second accommodation groove 46. Therefore, each of the first accommodation groove 44 and the second accommodation groove 46 is configured to have a shape corresponding to the coupling member 32, and the shape of the first accommodation groove 44 and the second accommodation groove 46 is not limited to a rectangular form as illustrated on FIG. 5,.

The power cord 30 is coupled to the housing 11 of the dishwasher 10 through the power cord insertion hole 43. The open/close unit 41 which is equipped at the housing body 40 is lifted and the coupling member 32 of the power cord 30 is inserted into the power cord insertion hole 43. If the neck part 37 is coupled to the first accommodation groove 44 equipped at the open/close unit 41, the head part 36 is supported by the inner surface of the open/close unit 41. The power cord 30 is moved toward a bottom direction such that the open/close unit 41 is closed. The coupling member 32 and the open/close unit 41 may be moved easily through the second accommodation groove 26 equipped at the housing body 40. After coupling the fixing member 31 of the power cord 30 to the recess 47 formed at the housing body 40, the housing fastening hole 49 is fixed to the power cord fastening hole 34 by using the fastening member 48 such as a screw.

In a state that the power cord 30 is coupled, the first accommodation groove 44 and the second accommodation groove 46, which are respectively formed at a portion of the open/close unit 41 and the housing body 40, are closed by the fixing member 31 of the power cord 30, thereby preventing a foreign substance such as dust or a insect from entering and influencing a product.

According to the above described assembly method of the power cord 30, in a case when a component having a large volume such as the ferrite core 35 or the fuse holder (not shown) is coupled to the power cord 30, the open/close unit 42 equipped at the housing body 40 may be lifted, and therefore, coupling the power cord 30 to the inner side of the housing 11 is convenient. That is, there is no need to change the size of the power cord insertion hole 43 according to the size of the component connected to the rear of the coupling member 32 of the power cord 30 when the power cord 30 is assembled to the housing 11.

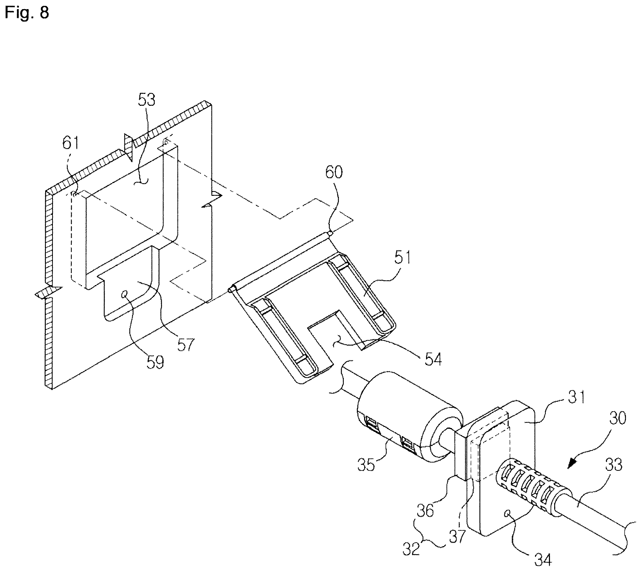

FIG. 8 is an exploded view illustrating a disassembled state of a dishwasher and a power cord

Referring to FIG. 8, the power cord insertion hole 43, which is configured for the power cord 30 to be coupled at one surface of the housing body 40, that is, a portion of the housing of the dishwasher 10, is provided. An open/close unit 51 is rotatably connected to the housing body 40, and three sides of the open/close unit 41 are incised. The open/close unit 41 is detachably coupled to the housing body 40. The open/close unit 51 includes a first accommodation groove 54 to accommodate a portion of the power cord 30.

A hinge 60 equipped at the open/close unit 41 is engaged to a hinge coupling hole 61equipped at the housing body 40 so that the open/close unit 40 may be detachably coupled to the housing body 40. The open/close unit 41 may rotate easily at the housing body 40 through the hinge coupling.

The housing body 40 includes a recess 57 which is formed in steps at the outer surface of the housing 11. The recess 57 is a portion where a portion of the fixing member 31 of the power cord 30 is coupled, and the shape of the recess 57 is formed to correspond to the shape of the fixing member 31.

The housing body 40 is provided at a lower side of with a housing fastening hole 59 to which a fastening member (not shown) is assembled such that the power cord 30 is coupled to the housing body 40. In a case when the recess 57 is formed, the housing fastening hole 59 may be equipped inside the recess 57.

The power cord 30, as described above, includes a fixing unit and the wire unit 33. The fixing unit includes the coupling member 32 which is coupled to the first accommodation groove 44 of the open/close unit 41 and the fixing member 31 which is fixed to the housing body 40. The coupling member 32 includes the neck part 37 which is inserted into the first accommodation groove 44 and the head part 26 which is supported by the inner surface of the open/close unit 41 when the neck part 37 is inserted into the first accommodation groove 44. In addition, the power cord fastening hole 34 into which the fastening member (not shown) is inserted may be provided at a lower side of the fixing member 31.

A portion of the fixing member 31 of the power cord 30 is supported by the outer surface of the open/close unit 41, and another portion of the fixing member 31 is supported by the housing body 40. In particular, another portion of the fixing member 31 may be supported by the recess 57.

In a case when the power cord 30 is coupled to the housing body 40, the power cord fastening hole 27 and the housing fastening hole 59, , are equipped in an overlapping manner. The fastening member (not shown) is inserted through the power cord fastening hole 34 and the housing fastening hole 59, and fixes the housing 11 of the dishwasher 10 to the power cord 30.

Although particular embodiments of the present disclosure have been illustrated and described, it would be appreciated by those skilled in the art that changes may be made in these embodiments without departing from the principles and spirit of the disclosure, the scope of which is defined in the claims and their equivalents. Although the above description has been made in relation that a power cord is coupled to a housing of a dishwasher, the power cord coupling structure of the present disclosure is not limited thereto. For example, the coupling structure is applicable to other electronic products using a power cord.

## Claims

1. A dishwasher (10) comprising a housing (11) configured to form an exterior, a tableware cleaning tub (12) formed at an inside of the housing, and a power cord (30) configured to supply a power, wherein the housing (11) comprises:
a housing body(40);
a power cord insertion hole (43, 53) which is provided at one side of the housing body (40) for a portion of the power cord (30) to be inserted into an inside of the housing (11); and
an open/close unit (41, 51) rotatably coupled to the housing body (40) to open/close the power cord insertion hole (43, 53), the open/close unit (44, 51) equipped with a first accommodation groove (44, 54) to accommodate the portion of the power cord (30) inserted into the inside of the housing, **characterized in that**
the power cord (30) comprises
a fixing unit configured to fix the power cord (30) to the housing body (40) when the open/close unit (41, 51) closes the power cord insertion hole (43, 53), the fixing unit comprising a coupling member (32) which is coupled to the first accommodation groove (44, 54) of the open/close unit, and a fixing member (31) which is fixed to the housing body (40).

2. The dishwasher of claim 1, wherein the coupling member (32) of the power cord (30) comprises a neck part (37) which is inserted into the first accommodation groove (44, 54) and a head part (36) which is supported by an inner side of the open/close unit (41, 51) when the neck part is inserted into the first accommodation groove.

3. The dishwasher of claim 2, wherein a portion of the fixing member (31) is disposed to be supported by an outer side of the open/close unit (41, 51), and another portion of the fixing member is disposed to be supported by an outer side of the housing body (40) when the open/close unit (41, 51) closes the power cord insertion hole (43, 53) in a state when the neck part (37) is inserted into the first accommodation groove.

4. The dishwasher of claim 1, wherein the housing body (40) comprises a second accommodation groove (46) which is formed to face the first accommodation groove (44) when the open/close unit (41) closes the power cord insertion hole (43).

5. The dishwasher of claim 1, wherein a portion of the coupling member (32) is disposed to be supported by an inner side of the housing body (40) when the open/close unit (41, 51) closes the power cord insertion hole (43, 53) in a state that the neck part (37) is inserted into the first accommodation groove.

6. The dishwasher of claim 4, wherein the first accommodation groove (44) of the open/close unit (41) and the second accommodation groove (46) of the housing body (40) face each other toward a first direction, and
a length of the first accommodation groove (44) toward the first direction is longer than a length of the second accommodation groove (46) toward the first direction.

7. The dishwasher of claim 1, further comprising:
a fastening member (48) which is configured to fix the fixing member (31) to the housing body (40).

8. The dishwasher of claim 1, further comprising:
a recess (47, 57) which is formed in steps at an outer side of the housing body (40).

9. The dishwasher of claim 1, wherein the open/close unit (41) is formed integrally with the housing body (40).

10. The dishwasher of claim 1, wherein the open/close unit (41) is detachably installed to the housing body (40).

11. The dishwasher of claim 1, wherein a ferrite core (35) is coupled to a rear of the coupling member (32) of the power cord (30) to restrain occurrence of low frequency noise.

## Patentansprüche

1. Geschirrspülmaschine (10) mit einem Gehäuse (11) zur Bildung eines äußeren Erscheinungsbildes, einer Tischgeschirreinigungstrommel (12), die im Inneren des Gehäuses gebildet ist und einem Netzanschlusskabel (30) zur Zufuhr von Leistung, wobei das Gehäuse (11) aufweist:
einen Gehäusekörper (40),
eine Netzanschlusskabeleinsatzöffnung (43, 53), welche an einer Seite des Gehäusekörpers (40) für einen Abschnitt des Netzanschlusskabels (30) zum Einsetzen in das Innere des Gehäuses (11) vorgesehen ist, und
eine Öffnungs-/Schließeinheit (41, 51) die drehbar an dem Gehäusekörper (40) zum Öffnen/Schließen der Netzanschlusskabeleinsatzöffnung (43, 53) angekoppelt ist, wobei die Öffnungs-/Schließeinheit (44, 51) mit einer ersten Aufnahmenut (44, 54) zur Aufnahme des Abschnitts des Netzanschlusskabels (30) ausgebildet ist, welcher in das Innere des Gehäuses eingesetzt ist, **dadurch gekennzeichnet, dass**
das Netzanschlusskabel (30) eine Fixiereinheit aufweist, die zum Fixieren des Netzanschlusskabels (30) am Gehäusekörper (40) ausgebildet ist, wenn die Öffnungs-/Schließeinheit (41, 51) die Netzanschlusskabeleinsatzöffnung (43, 53) schließt, wobei die Fixiereinheit ein Kopplungsbauteil (32) aufweist, welches mit der ersten Aufnahmenut (44, 54) der Öffnungs-/Schließeinheit gekoppelt ist, sowie ein Fixierbauteil (41) aufweist, welches an dem Gehäusekörper (40) fixiert ist.

2. Geschirrspülmaschine nach Anspruch 1, wobei das Kopplungsbauteil (32) des Netzanschlusskabels (30) ein Halsteil (37), welches in die erste Aufnahmenut (44, 54) eingesetzt ist, und ein Kopfteil (36) aufweist, welches durch eine Innenseite der Öffnung-/Schließeinheit (41, 51) abgestützt ist, wenn der Halsteil in die erste Aufnahmenut eingesetzt ist.

3. Geschirrspülmaschine nach Anspruch 2, wobei ein Abschnitt des Fixierbauteils (31) angeordnet ist zum Tragen durch eine Außenseite der Öffnungs-/Schließeinheit (41, 51) und ein weiterer Abschnitt des Fixierbauteils angeordnet ist zum Tragen durch eine Außenseite des Gehäusekörpers (40), wenn die Öffnungs-/Schließeinheit (41, 51) die Netzanschlusskabeleinsatzöffnung (43, 53) in einem solchen Zustand schließt, in dem der Halsteil (37) in die erste Aufnahmenut eingesetzt ist.

4. Geschirrspülmaschine nach Anspruch 1, wobei der Gehäusekörper (40) eine zweite Aufnahmenut (46) aufweist, die zum Gegenüberliegen zur ersten Aufnahmenut (44) gebildet ist, wenn die Öffnungs-/Schließeinheit (41) die Netzanschlusskabeleinsatzöffnung (43) schließt.

5. Geschirrspülmaschine nach Anspruch 1, wobei ein Abschnitt des Kopplungsbauteils (32) angeordnet ist zum Abstützen durch eine Innenseite des Gehäusekörpers (40), wenn die Öffnungs-/Schließeinheit (41, 51) die Netzanschlusskabeleinsatzöffnung (43, 53) in einem Zustand schließt, in dem der Halsteil (37) in die erste Aufnahmenut eingesetzt ist.

6. Geschirrspülmaschine nach Anspruch 4, wobei die erste Aufnahmenut (44) der Öffnungs-/Schließeinheit (41) und die zweite Aufnahmenut (46) des Gehäusekörpers (40) einander in einer ersten Richtung gegenüberliegen und einer Länge der ersten Aufnahmenut (44) in Richtung der ersten Richtung länger als eine Länge der zweiten Aufnahmenut (46) in Richtung der ersten Richtung ist.

7. Geschirrspülmaschine nach Anspruch 1, welche weiterhin aufweist:
ein Befestigungsbauteil (48), welches ausgebildet ist zum Befestigen des Fixierbauelements (31) an dem Gehäusekörper (40).

8. Geschirrspülmaschine nach Anspruch 1, welche weiterhin aufweist:
eine Ausnehmung (47, 57), welche in Stufen an einer Außenseite des Gehäusekörpers (40) gebildet ist.

9. Geschirrspülmaschine nach Anspruch 1, wobei die Öffnungs-/Schließeinheit (41) einteilig mit dem Gehäusekörper (40) gebildet ist.

10. Geschirrspülmaschine nach Anspruch 1, wobei die Öffnungs-/Schließeinheit (41) lösbar an dem Gehäusekörper (40) installiert ist.

11. Geschirrspülmaschine nach Anspruch 1, wobei ein Ferritkern (35) an einer Rückseite des Kopplungsbauteils (32) des Netzanschlusskabels (30) gekoppelt ist, um das Auftreten von Niedrigfrequenzrauschen zu begrenzen.

## Revendications

1. Lave-vaisselle (10) comprenant une structure rigide (11) configurée pour former un extérieur, une cuve de nettoyage de vaisselle (12) formée à l'intérieur de la structure rigide, et un cordon d'alimentation (30) configuré pour alimenter de l'énergie, la structure rigide (11) comprenant :
un corps de structure rigide (40) ;
un trou d'insertion de cordon d'alimentation (43, 53) qui est prévu au niveau d'un côté du corps de structure rigide (40) pour une partie du cordon d'alimentation (30) à insérer à l'intérieur de la structure rigide (11) ; et
une unité d'ouverture/fermeture (41, 51) couplée de manière à pouvoir tourner au corps de structure rigide (40) pour ouvrir/fermer le trou d'insertion de cordon d'alimentation (43, 53), l'unité d'ouverture/fermeture (44, 51) équipée d'une première rainure de réception (44, 54) pour recevoir la partie du cordon d'alimentation (30) insérée à l'intérieur de la structure rigide, **caractérisé en ce que**
le cordon d'alimentation (30) comprend
une unité de fixation configurée pour fixer le cordon d'alimentation (30) au corps de structure rigide (40) lorsque l'unité d'ouverture/fermeture (41, 51) ferme le trou d'insertion de cordon d'alimentation (43, 53), l'unité de fixation comprenant un élément de couplage (32) qui est couplé à la première rainure de réception (44, 54) de l'unité d'ouverture/fermeture, et un élément de fixation (31) qui est fixé au corps de structure rigide (40).

2. Lave-vaisselle selon la revendication 1, l'élément de couplage (32) du cordon d'alimentation (30) comprenant une partie formant col (37) qui est insérée dans la première rainure de réception (44, 54) et une partie de tête (36) qui est supportée par un côté interne de l'unité d'ouverture/fermeture (41, 51) lorsque la partie formant col est insérée dans la première rainure de réception.

3. Lave-vaisselle selon la revendication 2, une partie de l'élément de fixation (31) étant disposée pour être supportée par un côté externe de l'unité d'ouverture/fermeture (41, 51), et l'autre partie de l'élément de fixation étant disposée pour être supportée par un côté externe du corps de structure rigide (40) lorsque l'unité d'ouverture/fermeture (41, 51) ferme le trou d'insertion de cordon d'alimentation (43, 53) sous un état dans lequel la partie formant col (37) est insérée dans la première rainure de réception.

4. Lave-vaisselle selon la revendication 1, le corps de structure rigide (40) comprenant une seconde rainure de réception (46) qui est formée pour faire face à la première rainure de réception (44) lorsque l'unité d'ouverture/fermeture (41) ferme le trou d'insertion de cordon d'alimentation (43).

5. Lave-vaisselle selon la revendication 1, une partie de l'élément de couplage (32) étant disposée pour être supportée par un côté interne du corps de logement (40) lorsque l'unité d'ouverture/fermeture (41, 51) ferme le trou d'insertion de cordon d'alimentation (43, 53) sous un état sous lequel la partie formant col (37) est insérée dans la première rainure de réception.

6. Lave-vaisselle selon la revendication 4, la première rainure de réception (44) de l'unité d'ouverture/fermeture (41) et la seconde rainure de réception (46) du corps de structure rigide (40) se faisant face l'une l'autre par rapport à un premier sens, et
une longueur de la première rainure de réception (44) vers le premier sens est plus longue qu'une longueur de la seconde rainure de réception (46) vers le premier sens.

7. Lave-vaisselle selon la revendication 1, comprenant en outre :
un élément de fixation (48) qui est configuré pour fixer l'élément de fixation (31) au corps de structure rigide (40).

8. Lave-vaisselle selon la revendication 1, comprenant en outre :
un renfoncement (47, 57) qui est formé de paliers au niveau d'un côté externe du corps de structure rigide (40).

9. Lave-vaisselle selon la revendication 1, l'unité d'ouverture/fermeture (41) étant formée intégralement avec le corps de structure rigide (40).

10. Lave-vaisselle selon la revendication 1, l'unité d'ouverture/fermeture (41) étant installée au niveau du corps de structure rigide (40) de manière à pouvoir être détachée.

11. Lave-vaisselle selon la revendication 1, un noyau de ferrite (35) étant couplé à l'arrière de l'élément de couplage (32) du cordon d'alimentation (30) pour restreindre l'apparition de bruit de basse fréquence.
